# EUROPEAN PATENT APPLICATION

(11) **EP 4 068 382 A1**
(43) Date of publication of application: **05.10.2022**
(21) Application number: 20896344.7
(22) Date of filing: 10.11.2020
(51) Int. Cl.: H01L 27/32

(54) **DISPLAY SCREEN ASSEMBLY AND ELECTRONIC DEVICE**

(30) Priority: 03.12.2019 CN 201911222519
(71) Applicant: GUANGDONG OPPO MOBILE TELECOMMUNICATIONS CORP., LTD., Dongguan, Guangdong 523860 (CN)
(72) Inventor: ZHANG, Haiyu, Dongguan, Guangdong 523860 (CN); SUN, Zhou, Dongguan, Guangdong 523860 (CN)
(74) Representative: Ipside
(86) International application number: PCT/CN2020/127738
(87) International publication number: WO 2021/109805

(57) **Abstract**

Disclosed is a display screen assembly comprising a display screen. The display screen comprises a first display region and a second display region. The first display region comprises multiple pixel units. The pixel unit comprises one or more subpixels. Anodes of at least two subpixels in at least one pixel unit have different shapes, or the anodes have the same shape but are arranged in different directions. Alternatively, anodes of subpixels in adjacent pixel units have different shapes, such that anodes of different subpixels have different diffraction directions. In the above structure, anodes of at least a portion of subpixels have different shapes, or the anodes are arranged in different directions, such that anodes of different subpixels have different diffraction directions, thereby preventing or reducing superimposition. Dispersion of anode diffractions further reduces any effect on the imaging performance of a camera module. Also provided is an electronic device comprising the above display screen assembly.

## Description

### TECHNICAL FIELD

The present disclosure relates to the field of electronic devices, and in particular to a display screen assembly and an electronic device.

### BACKGROUND

Electronic devices, such as mobile phones, tablet computers, etc., include display screens. The display screen includes a plurality of pixel units, and each of the pixel units includes a plurality of pixels. An anode diffraction may be generated during the operation of the pixels. It is more likely to generate more serious anode diffractions between the pixels of the display screen before improved, resulting in affecting the shooting effect of a camera.

### SUMMARY OF THE DISCLOSURE

The present disclosure provides a display screen assembly and an electronic device.

According to a first aspect of the present disclosure, a display screen assembly is provided and includes: a display screen including a first display region and a second display region. The first display region includes a plurality of pixel units, and the pixel unit includes one or more subpixels. Anodes of at least two subpixels of at least one pixel unit have different shapes, or have the same shape but are arranged in a direction different from each other, or the anodes of the subpixels of adjacent pixel units have different shapes, such that anode diffractions generated by different subpixels have different directions.

According to a second aspect of the present disclosure, a display screen assembly is provided and includes: a display screen including a first display region and a second display region. In the first display region, pixel units in at least two columns or rows are arranged in a non-aligning way. The pixel unit includes one or more subpixels. Anodes of at least two subpixels of at least one pixel unit have different shapes, or the anodes of the subpixels of adjacent pixel units have different shapes, such that anode diffractions generated by different subpixels have different directions.

According to a third aspect of the present disclosure, a display screen assembly is provided and includes a display screen including a first display region and a second display region. The first display region includes a plurality of columns of pixel units and a plurality of rows of pixel units, and pixel units in at least two columns or rows are arranged in a non-aligning way. Anodes of at least two subpixels of at least one pixel unit have different shapes, or the anodes of the subpixels in adjacent pixel units have different shapes, such that anode diffractions generated by different subpixels have different directions.

According to a fourth aspect of the present disclosure, an electronic device is provided and includes a housing, a camera module, and a display screen assembly. The display screen assembly includes a display screen including a first display region and a second display region. The first display region includes a plurality of pixel units, and the pixel units includes one or more subpixels. Anodes of at least two subpixels of at least one pixel unit have different shapes, or have the same shape but are arranged in a direction different from each other, or the anodes of the subpixels of adjacent pixel units have different shapes, such that anode diffractions generated by different subpixels have different directions. The display screen assembly is fixedly connected with the housing, and the camera module is overlapped with the first display region of the display screen.

According to a fifth aspect of the present disclosure, an electronic device is provided and includes a housing, a camera module, and a display screen assembly. The display screen assembly includes a display screen including a first display region and a second display region. In the first display region, pixel units in at least two columns or rows are arranged in a non-aligning way. The pixel units include one or more subpixels. Anodes of at least two subpixels of at least one pixel unit have different shapes, or the anodes of the subpixels in adjacent pixel units have different shapes, such that anode diffractions generated by different subpixels have different directions. The display screen assembly is fixedly connected with the housing, and the camera module is overlapped with the first display region of the display screen.

According to a sixth aspect of the present disclosure, an electronic device is provided and includes a housing, a camera module, and a display screen assembly. The display screen assembly includes a display screen including a first display region and a second display region. The first display region includes a plurality of columns of pixel units and a plurality of rows of pixel units, and pixel units in at least two columns or rows are arranged in a non-aligning way. Anodes of at least two subpixels of at least one pixel unit have different shapes, or the anodes of the subpixels in adjacent pixel units have different shapes, such that anode diffractions generated by different subpixels have different directions. The display screen assembly is fixedly connected with the housing, and the camera module is overlapped with the first display region of the display screen.

The display screen assembly according to the embodiments of the present disclosure includes the display screen. More specifically, a displaying includes the first display region and the second display region. The first display region is configured to be overlapped with the camera module. That is, the first display region is configured to display, and at the same time, the first display region is also configured for light rays outside the electronic device passing through, and the light rays, thereby the camera module overlapped with the first display region completing shooting. The first display region according to the embodiments of the present disclosure includes a plurality of pixel units, and the pixel unit includes one or more subpixels. The anodes of at least two subpixels of at least one pixel unit have different shapes, or have the same shape but are arranged in the direction different from each other, or the anodes of the subpixels of the adjacent pixel units have the different shapes, such that anode diffractions generated by the different subpixels have different directions, thereby preventing the anode diffractions from being superimposed or reducing the superposition. In this way, the anode diffractions generated by the subpixels are dispersed, thereby reducing the impact on the imaging effect of the camera module, and achieving a better imaging effect.

### BRIEF DESCRIPTION OF THE DRAWINGS

In order to illustrate technical solutions of embodiments of the present disclosure in details, drawings required for illustrating the embodiments will be described in brief. Obviously, the following drawings illustrate only some embodiments of the present disclosure, and to any one of skill in the related art, other drawings may be obtained based on the following drawings without any creative work.
FIG. 1 is a structural view of a display screen assembly according to an embodiment of the present disclosure.
FIG. 2 is a structural view of an electronic device according to an embodiment of the present disclosure.
FIG. 3 is a structural view of a pixel unit according to an embodiment of the present disclosure.
FIG. 4 is a schematic view of a shape of an anode and diffraction directions of the anode of a subpixel according to an embodiment of the present disclosure.
FIG. 5 is a schematic view of the shape of the anode and diffraction directions of the anode of the subpixel according to another embodiment of the present disclosure.
FIG. 6 is a structural view of a display screen assembly before improved according to an embodiment.
FIG. 7 is a structural view of a shape of anodes of subpixels of pixel units in pixel units before improved according to an embodiment.
FIG. 8 is a structural view of the shape of the anodes of the subpixels of the pixel units before improved according to another embodiment.
FIG. 9 is a structural view of the shape of the anodes of the subpixels of pixel units before improved according to another embodiment.
FIG. 10 is a structural view of a shape of anodes of subpixels of pixel units of the display screen assembly according to an embodiment of the present disclosure.
FIG. 11 is a structural view of the shape of the anodes of the subpixels of the pixel units according to another embodiment of the present disclosure.
FIG. 12 is a structural view of the shape of the anodes of the subpixels of the pixel unit according to another embodiment of the present disclosure.
FIG. 13 is a structural view of the shape of the anodes of pixels of the pixel units according to another embodiment of the present disclosure.
FIG. 14 is a structural view of the shape of the anodes of pixels of the pixel units according to another embodiment of the present disclosure.
FIG. 15 is a partially cross-sectional view of the electronic device according to another embodiment of the present disclosure.

### DETAILED DESCRIPTION

The present disclosure will now be described in detail with reference to the accompanying drawings and examples. It should be understood that, the specific embodiments described herein are only used to interpret the present disclosure and are not used to limit the scope of the present disclosure. In addition, for convenience of description, it should be noted that the described drawings are only a part of the embodiments of the present disclosure, not all of the embodiments. All other embodiments obtained by a person of ordinary skill in the art based on the embodiments of the present disclosure without creative efforts shall fall within the protection scope of the present disclosure.

The embodiments of the present disclosure mean that a particular feature, a structure, or a characteristic described in detail with reference to the accompanying embodiments can be included in at least an embodiment of the present disclosure. The appearances of the phrase in various places in the specification are not necessarily all referring to the same embodiment, nor a separate or alternative embodiment that is mutually exclusive with other embodiments. It is explicitly and implicitly understood by those skilled in the art that the embodiments described herein may be combined with other embodiments.

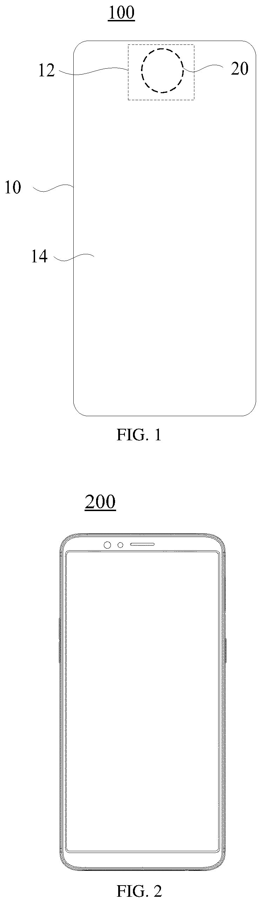

A display screen assembly 100 and an electronic device 200 including the display screen assembly 100 are provided by the present disclosure. As shown in FIG. 1, FIG. 1 is a structural view of a display screen assembly according to an embodiment of the present disclosure. FIG. 2 is a structural view of an electronic device according to an embodiment of the present disclosure. In an embodiment, the electronic device 200 may be any one of various types of computer system equipment that are mobile or portable and perform wireless communications (only an exemplary form as shown in FIG. 2). In another embodiment, the electronic device 200 may be a mobile phone or a smart phone (the mobile phone or the smart phone based on an iPhone TM or an Android TM), a portable gaming device (such as a Nintendo DS TM, a PlayStation Portable TM, a Gameboy Advance TM, an iPhone TM), a laptop computer, or a PDA, a portable internet device, a music player, a data storage device, other handheld device, a headphone, or the like. Furthermore, the electronic device 200 may also be other wearable device that needs charging, such as an electronic bracelet, an electronic necklace, an electronic equipment, or a head mount display (HMD) of a smart watch.

Besides, the electronic device 200 may also be any one of a plurality of electronic devices. The plurality of electronic devices include but not limited to cellular phones, smart phones, other wireless communication devices, personal digital assistants, audio players, other media players, music recorders, video recorders, other media recorders, radios, medical equipment, vehicle transportation instruments, calculators, programmable remote controls, pagers, laptops, desktops, printers, netbooks, personal digital assistants (PDA), portable multimedia players (PMP), moving picture expert groups (MPEG-1 or MPEG-1) -2), audio layer players (MP3), portable medical devices, devices such as digital cameras, or combinations thereof.

In some cases, the electronic device 200 may perform various function, such as playing music, displaying video, storing pictures, and receiving and sending telephone calls. If required, the electronic device 200 may be a cellular phone, a media player, other handheld device, a wristwatch device, a pendant device, a handset device, or other compact portable device.

As shown in FIG. 1, the display screen assembly 100 includes a display screen 10. A camera module 20 is overlapped on a side of the display screen 10.

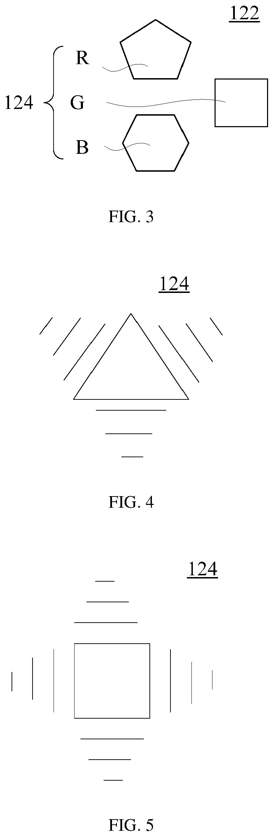

, the display screen 10 is a member of the electronic device 200 that displays pictures or videos, such as LCD, OLED/QLED, microled/minled, or the like. In another embodiment y, the display screen 10 includes a first display region 12 and a second display region 14. The first display region 12 is far smaller than the second display region 14. The camera module 20 is overlapped with the first display region 12. In another embodiment, on the one hand, the first display region 12 is configured to display, and on the other hand, at the same time, the first display region 12 is also configured for light rays outside the electronic device 200 passing through, and the light rays is received by the camera module 20 under the first display region 12, thereby completing shooting. In another embodiment, the first display region 12 includes a plurality of pixel units 122. Each of the pixel units 122 includes one or more subpixels 124. For example, the pixel units 122 include R pixel, G pixel, and B pixel, as shown in FIG. 3. In some embodiments, some of the pixel units 122 or all of the pixel units 122 only include one or two subpixels. It should be appreciated that, because the camera module 20 is arranged on the one side of the first display region 12, more light rays can pass through the first display region 12 and be received by the camera module 20 by removing one subpixel 124, or some of the subpixels 124 of the plurality of pixel units 122.

It should be appreciated that terms such as "first", "second", and "third" are used herein for purposes of description, and are not intended to indicate or imply relative importance or significance or to imply the number of indicated technical features. Thus, the feature defined with "first", "second", and "third" may include one or more of such a feature.

It should be appreciated that an anode diffraction may be generated during the operation of the subpixels 124 of each the pixel unit 122. A direction of the anode diffraction generated by the subpixel 124 is related to a shape of the anode of the subpixels 124. For example, if the shape of the anode of the subpixel 124 is triangular, the anode diffraction generated by the subpixel 124 has three directions, as shown in FIG. 4. If the shape of the anode of the subpixel 124 is quadrilateral, the anode diffraction generated by the subpixel 124 has four directions, as shown in FIG. 5. That is, as many sides are included in the shape of the anode of the pixel, there are as many directions of the anode diffraction generated by the subpixel 124.

In order to better illustrate an improvement of the present disclosure, a structure of pixel unit 122a in a first display area 12a of a display screen assembly 100a whose structure is before improved is firstly described below.

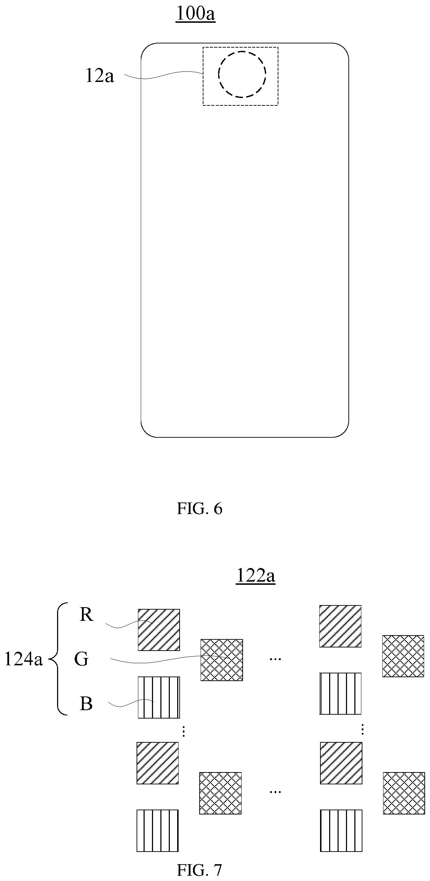

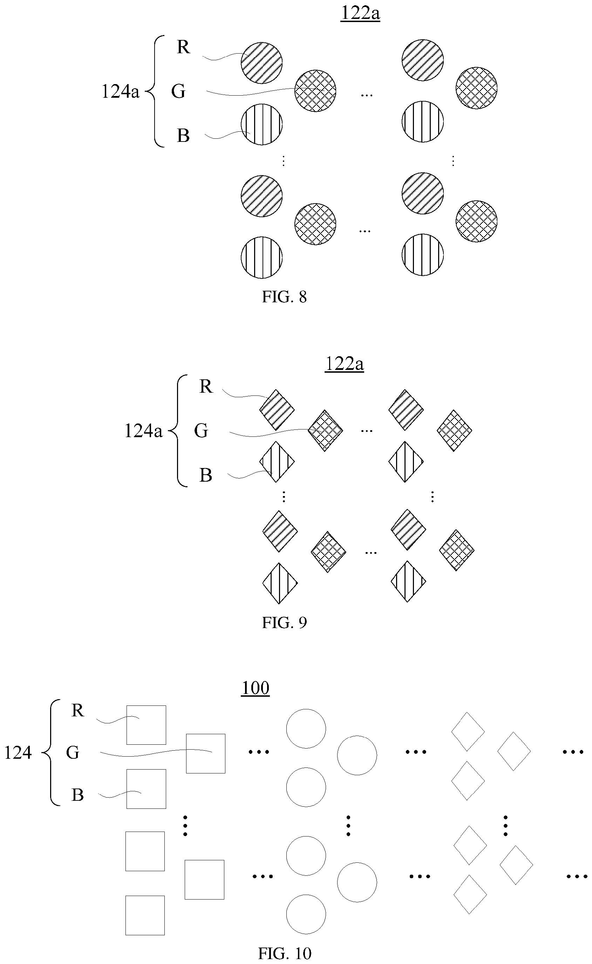

Before improved, all anodes of subpixels 124a of all the pixel units 122a in the first display area 12a have the same shape. For example, all of the same shape is rectangular, as shown in FIG. 6 and FIG. 7. Alternatively, all of the same shape is circular, as shown in FIG. 8. Alternatively, all of the same shape is diamond-shaped, as shown in FIG. 9. Alternatively, all of the same shape is pentagons, etc. Furthermore, the pixel units in all rows and all columns are arranged in an aligned manner. With the above structures, the anode which has the same shape has the same diffraction direction. In addition, anode diffractions generated by adjacent subpixels 124a have the same direction and are superimposed. Coupled with an aligned periodic arrangement, an effect of the anode diffractions will be superimposed again. As a result, the anode diffractions are aggravated too much, such that the shooting of the camera module 20 is affected, thereby resulting in a poor imaging effect of the camera module 20. As shown in FIG. 7, the anode diffractions generated by the subpixels 124a are concentrated in horizontal and vertical directions, when the shape of all the anodes of the subpixels 124a is rectangular. As shown in FIG. 8, the anode diffractions generated by the subpixels 124a are circles, when the shape of the anodes of all the subpixels 124a is circular. As shown in FIG. 9, the anode diffractions generated by the subpixels 124a are concentrated at 45° and 135°, when the shape of the anodes of all the subpixels 124a is diamond-shaped. The anode diffractions generated by the subpixels 124a with the above structure are relatively severe, such that the imaging effect of the camera module 20a is greatly affected.

At least one of the anodes of the subpixels 124 of the pixel unit 122 of the first display region 12 provided by the present disclosure has a shape different from that of an another one of the anodes. Alternatively, the at least one of the anodes of the subpixels 124 of at least one of the pixel units 122 has the same shape, but is arranged in a direction different from that of the another one of the anodes of the subpixels of the same one of the pixel units such that the anode diffraction generated by one of the different subpixels 124 has a direction different from that of another one of the different subpixels 124, thereby preventing the anode diffractions generated by the different subpixels 124 of the same pixel unit from being superimposed or reducing superposition, thus reducing an impact on the imaging effect of the camera module 20. In other embodiments, the anodes of the subpixels 124 of adjacent pixel units 122 have different shapes, such that the anode diffractions generated by the subpixels 124 of the adjacent pixel units 122 have different directions, thereby preventing the anode diffractions from being superimposed or reducing the superposition.

For example, as shown in FIG. 10, all of the anodes of the subpixels 124 of the pixel unit 122 in a first column have the same shape, and all of the anodes of the subpixels 124 of the pixel unit 122 in a second column have the same shape. However, the shape of the anodes of the subpixels 124 of the pixel unit 122 in the first column is different from that of the anodes of the subpixels 124 of the pixel unit 122 in the second column. The above embodiments only take the first column and the second column as an example. In other embodiments, any two adjacent columns or more columns may be used for the above settings, which is not limited herein. Similarly, the above settings may also be used for rows of the pixel unit 122, which will not be repeated in detail here.

It would be appreciated that with the above structures, even if the pixels 124 of the same pixel unit 122 are located closely, the anode diffraction generated by each subpixel 124 has a direction different from each other, such that there is no superposition or the superposition is reduced. Alternatively, the anode diffractions generated by the subpixels 124 of an adjacent pixel unit 122 have different directions, such that it is difficult to form the superposition or the superposition is reduced. In this case, it is possible that all the anode diffractions generated by the pixels 124 of the first display region 12 are dispersed and more uniform, thus the impact on the imaging effect of the camera module 20 are greatly reduced.

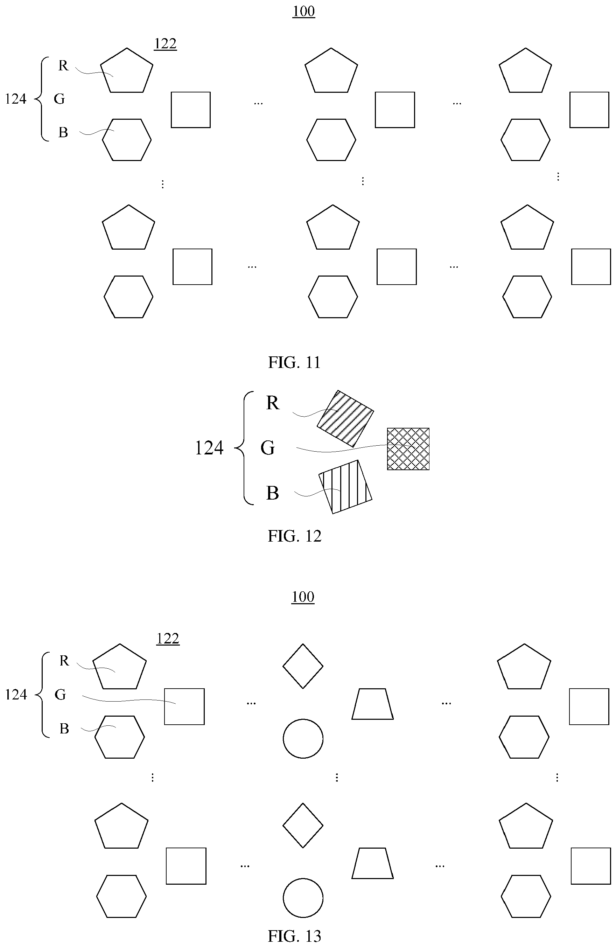

In an embodiment, all the anodes of the subpixels 124 of each pixel unit 122 of the first display region 12 have different shapes. For example, a shape of the anode of the R pixel is the pentagons, a shape of the anode of the G pixel is hexagon, and a shape of the anode of the B pixel is quadrilateral, as shown in FIG. 11. The anodes of the subpixels 124 of the adjacent pixel units 122 or the same pixel unit 122 have the different shapes, such that anode diffractions generated by the subpixels 124 of the adjacent pixel units 122 have the different directions, thereby preventing the anode diffractions from being superimposed or reducing the superposition. As shown in FIG. 12, the shape of all of the anodes of the subpixels of the same pixel unit is the quadrilateral, but at least one of the all of the anodes of the subpixels is arranged in a direction different from that of another one of the anodes, thus the anode diffractions generated by the subpixels 124 are in the different directions. With the above structures, the anodes of three nearest subpixels 124 have different shapes, or are arranged in a direction different from each other, such that the anode diffractions generated by each of the three nearest subpixels 124 have different directions, thus there is no superposition or the superposition is reduced, thereby greatly reducing the impact on the imaging effect of the camera module 20.

In an embodiment, the adjacent, non-adjacent pixel unit 122, or the different pixel units 122 are arranged with the subpixels 124, and the anodes of subpixels 124 have the same shape, or the different shapes. In another embodiment, in the first display region 12, the anodes of the subpixels 124 of each pixel unit 122 in the same column have the same shape which is different from that of the anodes of the subpixels 124 of the pixel units 122 in an adjacent column, as shown in FIG. 13. For example, in the same column, each pixel unit 122 is the same, that is, the anodes of the same subpixels 124 of each pixel units 122 have the same shape. For example, all of the anodes of the R pixels of the pixel unit 122 in the same column have the same shape. For example, all of the anodes of the G pixels of the pixel unit 122 in the same column have the same shape. For example, all of the anodes of the B pixels of the pixel unit 122 in the same column have the same shape. However, the anodes of different types of the subpixels 124 have the different shapes, that is, the shapes of the anodes of the R pixel, the G pixel, and the B pixel are different from each other. Similarly, the pixels in the different columns may be different or the same, which is not limited herein. For example, the anodes of the subpixels 124 of the pixel units 122 in adjacent columns have the different shapes. For example, the shape of the anodes of the R pixels of the pixel unit 122 in a first column is different from that of the anodes of the R pixels of the pixel unit 122 in a second column. Similarly, the pixel unit in the rows may also be the above cases, which will not be repeated in detail here. The shape and distribution of the anodes of the subpixels 124 of the pixel units 122 in the same column or different columns will be described in details as follow. And the pixel units 122 in the rows are also similar, which will not be repeated here.

Furthermore, in an embodiment, the shape the anodes of the R pixels of the pixel unit 122 in the first column is different from that of the anodes of the G pixels or the B pixels of the pixel unit 122 in the second column. It would be appreciated that a distance between the subpixels 124 in adjacent columns is short, such that it is easy to form the superposition of the anode diffraction. In the embodiments, all of the anodes of the subpixels 124 in the adjacent column have different shapes. Alternatively, only a part of the anodes of the subpixels 124 have the same shape, but a distance between the part of the anodes of the subpixels 124 is long. In this case, the superposition of the anode diffraction generated by the adjacent subpixels 124 may be better reduced, or the superposition of that is not serious, thereby reducing the impact on the shooting effect of the camera module 20.

In another embodiment, all of the anodes of the pixels of the same type of the pixel unit 122 in the same column, such as all of the anodes of the G pixels or the G pixels or the B pixels in the same column, have different shapes. Alternatively, some of the anodes of the pixels have the same shape, but some of the anodes of the pixels have different shapes, which is not limited herein.

In an embodiment, the anodes of the subpixels 124 of the adjacent pixel units 122 of the first display region 12 have different shapes. For example, the anodes of the subpixels 124 of the pixel unit 122 in the first column have a shape which is different from that of the anodes of the pixels 124 of the pixel unit 122 in the second column.

In an embodiment, in the first display region 12, the anodes of the pixels 124 of the same type of each pixel unit 122 in the same column have the same shape. In an embodiment, the R pixel, the G pixel, and the B pixel are three types of the pixels. The anodes of the pixels 124 of the pixel unit 122 in the first column have a shape which is different from that of the anodes of the pixels 124 of the pixel unit 122 in the second column. The anodes of the pixels 124 of the pixel unit 122 in the first column have the same shape as that of the anodes of the pixels 124 of the pixel unit 122 in a third column. In this way, the pixels 124, the anodes of which have the same shape, are separated by one column, and a distance between the pixels 124 is long, such that it is difficult to form the superposition. In addition, the anodes of the pixels 124 of the pixel units 122 in the adjacent column have different shapes, such that the superposition of the anode diffraction is difficult to be formed, thereby reducing greatly the impact on the imaging effect of the camera module 20.

Furthermore, the pixels 124 of the pixel units 122 in different columns are formed with a constant period. For example, in the first display region 12, the anodes of the pixels 124 of the pixel unit 122 in an odd column have the same shape, and the anodes of the pixels 124 of the pixel unit 122 in an even column have the same shape. However, the shape of the anodes of the pixels 124 of the pixel units 122 in the odd column is different from that of the anodes of the pixels 124 of the pixel units 122 in the even column. In other words, a periodic law is formed in one column per interval. In other embodiments, the periodic law is formed in multiple columns per interval.

For example, in an embodiment, the shape of the anodes of the subpixels 124 of the pixel unit 122 in the first column is the same as that of the anodes of the subpixels 124 of the pixel unit 122 in a Nth column. The shape of the anodes of the subpixels 124 of the pixel unit 122 in the first column is different from that of the anodes of the subpixels 124 of the pixel unit 122 in middle columns between the first column and the Nth column. In the embodiments, the N may be any number above 3, which is not limited herein. It should be appreciated that the larger the N, the further a distance between two columns of the pixel units 122 which have the same shape, such that the less likely it is to form the superposition of the anode diffraction, and the worse a superposition effect is, thereby preventing affecting the shooting effect of the camera module 20 from being better.

Furthermore, in another embodiment, in the first display region, the anodes of the subpixels 124 of the pixel unit 122 in any two columns have different shapes. That is, in the first display region 12, the anodes of the subpixels 124 of the pixel units 122 in all the columns have different shapes, such that the anode diffraction of the subpixels 124 in the first display region 12 is more dispersed, thus there is no superposition or the superimposed effect is poor. In this way, during the operation of the subpixels 124, it is better to prevent the anode diffraction of the subpixels 124 from affecting the shooting effect of the camera module 20.

Furthermore, in another embodiment, in the first display region 12, the anodes of the subpixels 124 of all the pixel units 122 have different shapes. In this way, the anodes of the subpixels 124 in the first display region 12 have the different shapes, such that the anode diffractions generated by all the subpixels 124 have the different directions, thereby preventing the superposition of the subpixels 124 from being formed. In this case, the anode diffraction of the entire first display region 12 is more dispersed and more uniform, thereby having a less impact on the imaging effect of the camera module 20.

In the embodiments as described above, the anodes of the subpixels 124 have the different shapes, or the anodes of the different subpixels 124 of the same pixel unit 122 have the same shape but are arranged in the direction different from each other, thereby improving the problem of the superposition of the anode diffraction. In other embodiments, it may also be improved by the pixel units 122 arranged in a non-aligning way.

In an embodiment, in the first display region 12 of the display screen assembly 100, the pixel units 122 in at least two columns or rows are arranged in the non-aligning way. It should be appreciated that the superposition of the anode diffraction is generated by the subpixels 124 in the adjacent columns or rows, because the subpixels 124 are close to each other. In the first display region 12 of the present disclosure, the pixel units 122 in at least two columns or rows are arranged in the non-aligning way, such that a distance between at least some of the subpixels 124 of the pixel units 122 in the adjacent columns or rows is increased, thereby improving the problem of the severe superposition of the anode diffraction generated by the subpixels 124.

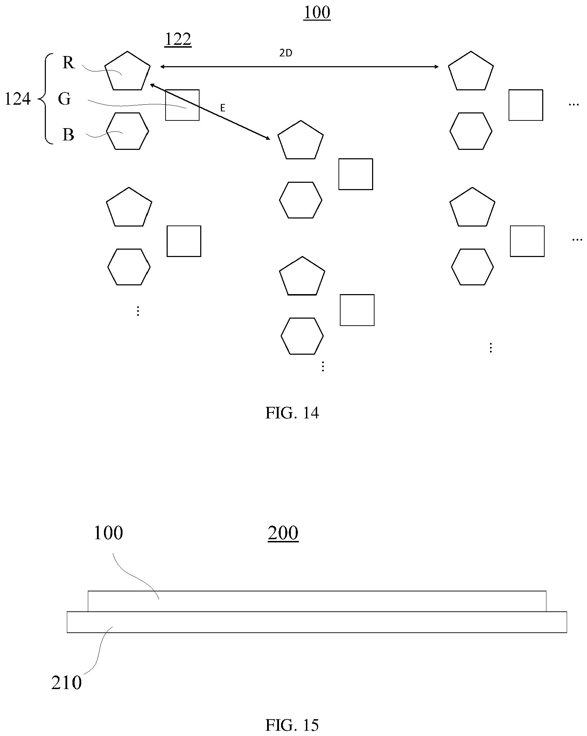

In another embodiment, in the first display region 12 of the display screen assembly, the pixel units 122 in the odd columns are aligned, the pixel units 122 in the even columns are aligned, and the pixel units 122 in the adjacent columns are not aligned, as shown in FIG. 14. For example, the pixel units 122 in the second column and first row is higher or lower than the pixel units 122 in the first column and first row, that is, the pixel units 122 in the second column and first row and the pixel units 122 in the first column and first row are staggered with respect to each other, and a distance between the pixel unit 122 in each row is consistent, such that the pixel units 122 in the same row of the odd columns and even columns are staggered with respect to each other. In this way, on the one hand, the distance between the adjacent pixel units 122 is increased. Even if the anodes of the pixels of the same type of the pixel units 122 in the odd column and even column have the same shape, a distance between the two pixels 124 the anodes of which have the same shape is larger, such that the superposition of the anode diffraction is smaller. For example, a distance E between a center point of the R pixel of the pixel units 122 in the first column and first row and a center point of the R pixel of the pixel units 122 in the second column and first row is larger than half of a distance between a center point of the R pixel of the pixel units 122 in the first column and first row and a center point of the R pixel of the pixel units 122 in the third column and first row, that is, a distance D shown in FIG. 14. With the above structures, the distance between the adjacent pixels 124 is increased in a staggered manner. Similarly, the pixel units 122 in the odd row are aligned, the pixel units 122 in the even row are aligned, and the pixel units 122 in the adjacent rows are not aligned. In other embodiments, the pixel units in the rows and columns are not aligned, which is not limited herein.

In another embodiment, the distance between the pixels 124 of the pixel units 122 of the adjacent columns may be increased by arranging the pixel units 122 in different columns or rows in the non-aligned manner.

In another embodiment, the pixel units 122 in the first column are aligned with the pixel units 122 in the Nth column, and the pixel units 122 in the first column and in the middle column among the Nth column are not aligned with the pixel units 122 in the adjacent columns. Similarly, the pixel units 122 in the rows are the same as that of the pixel units 122 in the columns as described above, which will not be repeated here.

In another embodiment, in the first display region 12, the pixel units 122 in any two columns are staggered with respect to each other. That is, in this embodiment, the pixels 124 in all of the columns are staggered with respect to each other, such that the distance between the adjacent pixels 124 of the pixel units 122 in the adjacent columns is increased, thereby improving the problem of the superposition of the anode diffraction generated by the pixels 124.

In other embodiments, based on that the pixels in the different rows or columns are not aligned, the anodes of the subpixels 124 have the different shapes, or the same shape but arranged in the direction different from each other, so as to further improve the problem of the superposition of the diffraction. The cases that the anodes of the subpixels 124 have the different shapes, or the same shape but arranged in the direction different from each other, are as described in the above embodiments, which is not limited herein.

In order to reduce the superposition of the anode diffraction, it should be appreciated that in different embodiments, the pixels 124 the anodes of which have the different shapes may be used alone to improve the problem of the superposition of the diffraction, or the pixel units 122 in the different columns staggered with respect to each other may be used alone to improve the problem of that. Of course, the above two solutions may also be used in combination, which is not limited herein.

It should be appreciated that the above solutions are mainly for the first display region 12. Of course, it can also be applied to the second display region 14, which is not limited herein.

In an embodiment, the first display region 12 can be arranged on any position of the display screen 10. In an embodiment, the first display region 12 is arranged on a top or corner of the display screen 10, or arranged on a position where users are less likely to focus on watching, such that it is not easy for the user to notice even if some of the pixels are dug out.

The electronic device 200 of the present disclosure includes a housing 210, the display screen assembly 100 as described in any of the above embodiments, and the camera module 20. As shown in FIG. 15, the display screen assembly 100 is fixedly connected with the housing 210, and the housing 210 is a carrier of the display screen assembly 100. In another embodiment, the housing 210 may be a middle frame of the electronic device 200, or a rear housing, or an integrated structure of the middle frame and the rear housing, which is not limited herein. The camera module 20 is overlapped with the first display region 12 of the display screen 10.

The above are only embodiments of the present disclosure and are not intended to limit the scope of the present disclosure. Any equivalent structural changes made under the concept of the present disclosure, using the contents of the specification of the present disclosure and the accompanying drawings, or applied directly/indirectly in other related fields of technology are included in the scope of protection of the present disclosure.

## Claims

1. A display screen assembly, **characterized by** comprising:
a display screen comprising a first display region and a second display region;
wherein the first display region comprises a plurality of pixel units, and the pixel unit comprises one or more subpixels;
wherein anodes of at least two subpixels of at least one pixel unit have different shapes, or have the same shape but are arranged in a direction different from each other, or the anodes of the subpixels of adjacent pixel units have different shapes, such that anode diffractions generated by different subpixels have different directions.

2. The display screen assembly according to claim 1, wherein all of the anodes of the subpixels of each pixel unit have different shapes.

3. The display screen assembly according to claim 1, wherein the anodes of the subpixels of the same pixel unit have the same shape which is different from that of the anodes of the subpixels of an adjacent pixel unit.

4. The display screen assembly according to claim 3, wherein in the first display region, the anodes of the subpixels of each the pixel unit in the same column have the same shape which is different from that of the anodes of the subpixels of the pixel units in an adjacent column.

5. The display screen assembly according to claim 1, wherein in the first display region, the anodes of the subpixels of the same type of each pixel unit in the same column have the same shape, the anodes of the subpixels of the same type of the pixel units in a first column have a shape which is the same as that of the anodes of the subpixels of the same type of the pixel units in a Nth column, and the anodes of the subpixels of the same type of the pixel units in the first column have the shape which is different from that of the anodes of the subpixels of the same type of the pixel units in middle columns between the first column and the Nth column.

6. The display screen assembly according to claim 3, wherein in the first display region, the anodes of the subpixels of the pixel units in any two columns have different shapes.

7. The display screen assembly according to claim 1, wherein in the first display region, the anodes of the subpixels of all the pixel units have different shapes.

8. A display screen assembly, **characterized by** comprising:
a display screen comprising a first display region and a second display region;
wherein in the first display region, pixel units in at least two columns or rows are arranged in a non-aligning way, and the pixel unit comprises one or more subpixels; wherein anodes of at least two subpixels of at least one pixel unit have different shapes, or the anodes of the subpixels of adjacent pixel units have different shapes, such that anode diffractions generated by different subpixels have different directions.

9. The display screen assembly according to claim 8, wherein the pixel units in an odd column are aligned, the pixel units in an even column are aligned, and the pixel units in adjacent columns are not aligned; or
the pixel units in an odd row are aligned, the pixel units in an even row are aligned, and the pixel units in adjacent rows are not aligned.

10. The display screen assembly according to claim 1, wherein in the first display region, the pixel units in a first column are aligned with the pixel units in a Nth column, and the pixel units in a middle column between the first column and the Nth column are not aligned with the pixel units in an adjacent column.

11. The display screen assembly according to claim 1, wherein the first display region is arranged on a top or corner of the display screen.

12. A display screen assembly, **characterized by** comprising:
a display screen comprising a first display region and a second display region;
wherein the first display region comprises a plurality of columns of pixel units and a plurality of rows of pixel units, and pixel units in at least two columns or rows are arranged in a non-aligning way;
wherein the pixel unit comprises one or more subpixels, anodes of at least two subpixels in at least one pixel unit have different shapes, or the anodes of the subpixels of adjacent pixel units have different shapes, such that anode diffractions generated by different subpixels have different directions.

13. The display screen assembly according to claim 12, wherein the pixel units in an odd column are aligned, the pixel units in an even column are aligned, and the pixel units in adjacent columns are not aligned; or
the pixel units in an odd row are aligned, the pixel units in an even row are aligned, and the pixel units in adjacent rows are not aligned.

14. The display screen assembly according to claim 12, wherein in the first display region, the pixel units in a first column are aligned with the pixel units in a Nth column, and the pixel units in a middle column between the first column and the Nth column are not aligned with the pixel units in an adjacent column.

15. The display screen assembly according to claim 12, wherein all of the anodes of the subpixels of each the pixel unit have different shapes.

16. The display screen assembly according to claim 12, wherein the anodes of the subpixels of the same pixel unit have the same shape which is different from that of the anodes of the subpixels of an adjacent pixel unit.

17. The display screen assembly according to claim 12, wherein in the first display region, the anodes of the subpixels of the same type of each pixel unit in the same column have the same shape, the anodes of the subpixels of the same type of the pixel units in a first column have a shape which is the same as that of the anodes of the subpixels of the same type of the pixel units in a Nth column, and anodes of the subpixels of the same type of the pixel units in the first column have the shape which is different from that of the anodes of the subpixels of the same type of the pixel units in middle columns between the first column and the Nth column.

18. An electronic device, **characterized by** comprising:
a housing, a camera module, and a display screen assembly;
wherein the display screen assembly comprises:
a display screen comprising a first display region and a second display region; wherein the first display region comprises a plurality of pixel units, and the pixel unit comprises one or more subpixels;
wherein anodes of at least two subpixels of at least one pixel unit have different shapes, or have the same shape but are arranged in a direction different from each other, or the anodes of the subpixels of adjacent pixel units have different shapes, such that anode diffractions generated by different subpixels have different directions;
wherein the display screen assembly is fixedly connected with the housing, and the camera module is overlapped with the first display region of the display screen.

19. An electronic device, **characterized by** comprising:
a housing, a camera module, and a display screen assembly;
wherein the display screen assembly comprises:
a display screen comprising a first display region and a second display region;
wherein in the first display region, pixel units in at least two columns or rows are arranged in a non-aligning way; the pixel unit comprises one or more subpixels, wherein anodes of at least two subpixels of at least one pixel unit have different shapes, or the anodes of the subpixels in adjacent pixel units have different shapes, such that anode diffractions generated by different subpixels have different directions;
wherein the display screen assembly is fixedly connected with the housing, and the camera module is overlapped with the first display region of the display screen.

20. An electronic device, **characterized by** comprising:
a housing, a camera module, and a display screen assembly;
wherein the display screen assembly comprises:
a display screen comprising a first display region and a second display region;
wherein the first display region comprises a plurality of columns of pixel units and a plurality of rows of pixel units, and pixel units in at least two columns or rows are arranged in a non-aligning way;
wherein anodes of at least two subpixels of at least one pixel unit have different shapes, or the anodes of the subpixels of adjacent pixel units have different shapes, such that anode diffractions generated by different subpixels have different directions;
wherein the display screen assembly is fixedly connected with the housing, and the camera module is overlapped with the first display region of the display screen.
